# EUROPÄISCHE PATENTSCHRIFT

(11) **EP 0 883 979 B1**
(45) Veröffentlichungstag und Bekanntmachung des Hinweises auf die Patenterteilung: **13.10.1999**
(21) Anmeldenummer: 96902848.9
(22) Anmeldetag: 29.02.1996
(51) Int. Cl.: H05K 13/00, H05K 13/04

(54) **VERFAHREN UND VORRICHTUNG ZUM AUFNEHMEN, ORIENTIEREN UND MONTIEREN VON BAUELEMENTEN**
METHOD AND DEVICE FOR RECEIVING, ORIENTATING AND ASSEMBLING OF COMPONENTS
PROCEDE ET DISPOSITIF POUR RECEPTIONNER, ORIENTER ET MONTER DES COMPOSANTS

(43) Veröffentlichungstag der Anmeldung: 16.12.1998
(73) Patentinhaber: Alphasem AG, 8572 Berg (CH)
(72) Erfinder: WIRZ, Gustav, CH-8572 Berg (CH); FORSTER, Martin, CH-8586 Riedt (CH)
(74) Vertreter: Wenger, René
(86) Internationale Anmeldenummer: CH9600064
(87) Internationale Veröffentlichungsnummer: WO9732460

(56) Entgegenhaltungen:
- EP-A- 0 257 546
- US-A- 4 624 050

## Beschreibung

Die Erfindung betrifft ein Verfahren zum taktweisen Aufnehmen, Zustellen und Absetzen eines vorzugsweise flächigen Werkstücks an einer Arbeitsstation, insbesondere an einem Chip-Bestückungsautomaten, gemäss dem Oberbegriff von Anspruch 1. Dabei müssen beispielsweise Chips von einem in der Aufnahmeebene angeordneten Wafer oder Magazin abgenommen und mit hoher Präzision und grosser Geschwindigkeit taktweise auf eine in der Abgabeebene liegende Unterlage abgesetzt werden.

Die Aufnahmeebene und die Abgabeebene können dabei parallel angeordnet sein und eventuell auch in der gleichen Ebene liegen. Der Zustellweg sollte jedoch so kurz wie möglich sein und die zu beschleunigenden Massen sollten ebenfalls gering sein. Durch eine Firmendruckschrift der Alphasem AG, CH-8572 Berg, Schweiz ist ein gattungsmässig vergleichbares Verfahren bzw. eine Vorrichtung bekannt geworden, bei welcher die Aufnahmeebene und die Abgabeebene im rechten Winkel zueinander angeordnet sind. Ein Schwenkarm mit einem einzigen Aufnahmekopf führt eine 90° Schwenkbewegung aus und transportiert dabei Chips von einem fest eingespannten Wafer auf taktweise vorbeigeführte Unterlagen. Die Taktgeschwindigkeit kann bei dieser Anordnung gegenüber anderen Transfereinheiten vergrössert werden.

Ein Nachteil aller bekannten Verfahren und Vorrichtungen besteht jedoch darin, dass die Werkstücke auf dem gesamten Zustellweg immer auf der gleichen Seite angefasst werden und dabei ihre relative Lage zur Transfereinheit nicht verändern. Eine Lageänderung während des Transports oder gar ein Wenden des flächigen Werkstücks um 180° ist dabei nicht möglich. Für bestimmte Anwendungsgebiete, insbesondere in der Elektronik, wäre es jedoch wünschenswert, das Werkstück mit der Oberseite nach unten abzusetzen.

Es ist daher eine Aufgabe der Erfindung, ein Verfahren der eingangs genannten Art zu schaffen, mit dessen Hilfe beim Zurücklegen des Zustellweges wahlweise eine relative Lageänderung des Werkstücks möglich ist. Insbesondere sollen an einem Chip-Bestückungsautomaten die von einem Wafer abgenommenen Dies mit der Aktivseite nach unten abgelegt werden können (Flip-Chip). Diese Aufgabe wird erfindungsgemäss mit einem Verfahren gelöst, das die Merkmale im Anspruch 1 aufweist.

Die Unterteilung des Zustellwegs in zwei verschiedene Zustelltakte ermöglicht es, das Werkstück an der im Bereich des Zustellwegs angeordneten Zwischenstation wahlweise in seiner Lage zu ändern, insbesondere ganz zu wenden. Da die Greifmittel im wesentlichen seitlich am Werkstück angreifen, bleibt die Oberseite und die Unterseite des Werkstücks frei, um es anzufassen. Durch den simultanen Transport eines Werkstücks von der Aufnahmeebene an die Zwischenstation und von der Zwischenstation an die Abgabeebene geht trotz des zweitaktigen Vorschubs keine Zeit verloren.

Für ein bestimmtes Arbeitsverfahren wird das Werkstück an der Aufnahmeebene an einer Oberseite erfasst und zur Zwischenstation transportiert. An der Zwischenstation wird es geflippt und an einer Unterseite gefasst, um mit der Oberseite auf die Abgabeebene abgesetzt zu werden. Selbstverständlich ist es aber auch denkbar, das Werkstück an der Zwischenstation wiederum auf der Oberseite zu fassen und es dabei in der gleichen Position zu belassen, oder ggf. durch Drehen um eine beliebige Raumachse lediglich in eine etwas andere Winkellage zu bringen, welche für den Weitertransport und/oder für das Absetzen an der Abgabeebene vorteilhafter ist. Vorteilhaft wird das Werkstück unabhängig von seiner Relativlage an der Zwischenstation zwischen einer Aufnahmeposition, in der das Werkstück eingespannt wird und einer Abgabeposition, in der das Werkstück abgegeben wird, in seiner Relativlage bezogen auf die Abgabeebene vorwärts bewegt. Dadurch kann der Bewegungsablauf vereinfacht werden und die Zwischenstation muss nicht exakt auf der Hälfte des Zustellwegs angeordnet werden.

Vorzugsweise wird das Werkstück an der Zwischenstation mittels einer pneumatisch aktivierbaren Klemmvorrichtung festgehalten, bei welcher flexible Schlauchabschnitte zum Klemmen aufgebläht und zum Lösen zusammengezogen werden. Auf diese Weise können ohne die Gefahr einer Beschädigung auch sehr dünne Bauteile exakt festgehalten werden. Störende Greifzangen oder dergleichen treten nicht in Erscheinung, so dass die gesamte Oberfläche des Werkstücks auf beiden Seiten frei bleibt. Je nach Beschaffenheit des Werkstücks ist es aber selbstverständlich auch möglich, dieses an der Zwischenstation mittels Klemmbacken festzuhalten. Diese Klemmbacken können auf verschiedene Weise am Werkstück angreifen und sie können motorisch angetrieben werden oder auch mit anderen Mitteln wie z.B. elektromagnetisch, durch Wärmeausdehnung, usw. aktiviert werden.

Die Erfindung betrifft auch eine Vorrichtung zum taktweisen Aufnehmen, Zustellen und Absetzen eines flächigen Werkstücks, welche die Merkmale im Anspruch 6 aufweist. Im Gegensatz zu den bekannten Vorrichtungen ist die Transfereinheit mit zwei Arbeitsköpfen ausgestattet, nämlich mit je einem Aufnahmekopf und mit einem Absetzkopf. Der Aufnahmekopf hat die Aufgabe, das Werkstück von der Aufnahmeebene zur Zwischenstation zu transportieren und der Absetzkopf holt das Werkstück dort ab und transportiert es zur Abgabeebene, wobei das Werkstück an der Zwischenstation wahlweise in seiner Seitenlage verändert werden kann. Diese Aufteilung in zwei Arbeitsköpfe hat zusätzlich auch noch den Vorteil, dass die Köpfe nur sehr kleine Wege zurücklegen müssen.

Die Zwischenstation ist derart um eine beiliebige Raumachse drehbar und/oder schwenkbar gelagert, dass das Werkstück an einer Oberseite mit dem Aufnahmekopf fassbar und in die Greifmittel einspannbar ist und dass es an einer Unterseite mit dem Absetzkopf fassbar und von den Greifmitteln abnehmbar ist. Dabei ist die Zwischenstation vorzugsweise um eine Drehachse drehbar an einem Schwenkhebel gelagert, der seinerseits um eine Schwenkhebelachse schwenkbar ist. Die Schwenkhebelachse ist dabei getriebemässig derart mit der Drehachse verbunden, dass beim Schwenken des Schwenkhebels die Drehachse wahlweise still- steht oder sich dreht. Durch diese relativ einfache Mechanik lässt sich die Zwischenstation im Verlaufe einer Schwenkbewegung des Schwenkhebels derart bewegen, dass die Schwenkbewegung kompensiert wird und das Werkstück auch am Ende der Schwenkbewegung noch die gleiche Relativlage einnimmt. Wird dagegen die Drehachse fixiert, schwenkt das eingespannte Werkstück mit und verändert auf diese Weise seine Relativlage.

Alternativ zur getriebemässigen Verbindung der Schwenkhebelachse mit der Drehachse kann selbstverständlich die Zwischenstation auch über einen separaten Antrieb bewegt werden, beispielsweise über einen unmittelbar an der Zwischenstation angeordneten Elektromotor oder über einen pneumatischen Antrieb.

Die Greifmittel an der Zwischenstation weisen vorteilhaft wenigstens eine flexible Berührungsfläche auf, welche zum Ergreifen des Werkstücks unter Druck aufblähbar und zum Loslassen des Werkstücks unter Vakuum zusammenziehbar ist. Die Greifmittel können dabei zwei im Abstand angeordnete Stützprofile aufweisen, wobei die flexiblen Berührungsflächen durch Schlauchabschnitte gebildet werden, welche über die Stützprofile geschoben sind. Alternativ kann eine Seite des Greifmittels als fester Anschlag ausgebildet sein, um eine definiertere Positionierung zu erreichen. Eine besonders zweckmässige Anordnung ergibt sich ferner, wenn die Stützprofile einseitig an einer Halterung befestigt sind, wenn die Schlauchabschnitte mit einem Hohlraum in der Halterung in Wirkverbindung stehen und wenn die Halterung um eine Drehachse drehbar ist, welche als Hohlachse ausgebildet ist, über welche der Hohlraum an eine Druckquelle oder an eine Vakuumquelle anschliessbar ist.

Um den Transportweg so kurz wie möglich zu halten, sind die Aufnahmeebene und die Abgabeebene unter einem Winkel von vorzugsweise 90° zueinander geneigt. Die Transfereinheit ist dabei als Schwenkarm ausgebildet, an dem in der gleichen Schwenkebene der Aufnahmekopf und der Abgabekopf winkelmässig versetzt zueinander angeordnet sind. Eine derartige Anordnung der Ebenen wird jedoch nicht in allen Anwendungsfällen möglich sein. Es ist daher ohne weiteres denkbar, dass die Aufnahmeebene und die Abgabeebene parallel zueinander verlaufen und zwar eventuell auch in ein und derselben Ebene. Die Transfereinheit könnte dabei eine lineare Bewegung ausführen oder sie könnte ebenfalls eine Schwenkbewegung ausführen, wobei aber die Schwenkebene parallel und nicht im rechten Winkel zur Aufnahmeebene bzw. zur Abgabeebene verlaufen würde. Wenn der Schwenkarm an einem in verschiedenen Raumachsen verschiebbaren Schlitten angeordnet ist, der auch die Zwischenstation trägt, können Werkstücke transferiert werden, die in der gleichen Ebene nebeneinander liegen. Der Schlitten fährt dann jeweils die Transfereinheit in die richtige Aufnahmeposition.

Ein Ausführungsbeispiel der Erfindung ist in den Zeichnungen dargestellt und wird nachstehend genauer beschrieben. Es zeigen:
- Figur 1: die perspektivische Darstellung einer Transfereinheit zum Transportieren von Chips oder Dies von einem Wafer auf eine Unterlage,
- Figur 2: ein Schnitt durch eine an einem Schwenkhebel befestigte Zwischenstation,
- Figur 3: eine schematische Darstellung der Zwischenstation beim Wenden eines Werkstücks,
- Figur 4: eine schematische Darstellung der Zwischenstation beim planparallelen Bewegen eines Werkstücks,
- Figur 5: ein stark vergrösserter Querschnitt durch die Greifmittel der Zwischenstation beim Klemmen eines Werkstücks,
- Figur 6: die Greifmittel gemäss Figur 5 beim Ablösen eines Werkstücks,
- Figuren 7a bis 7d: der Bewegungsablauf der Tranfereinheit gemäss Figur 1 bei einem Transfer mit Wendevorgang, und
- Figuren 8a bis 8d: die Transfereinheit gemäss Figur 1 bei einem Transfer ohne Wendevorgang.

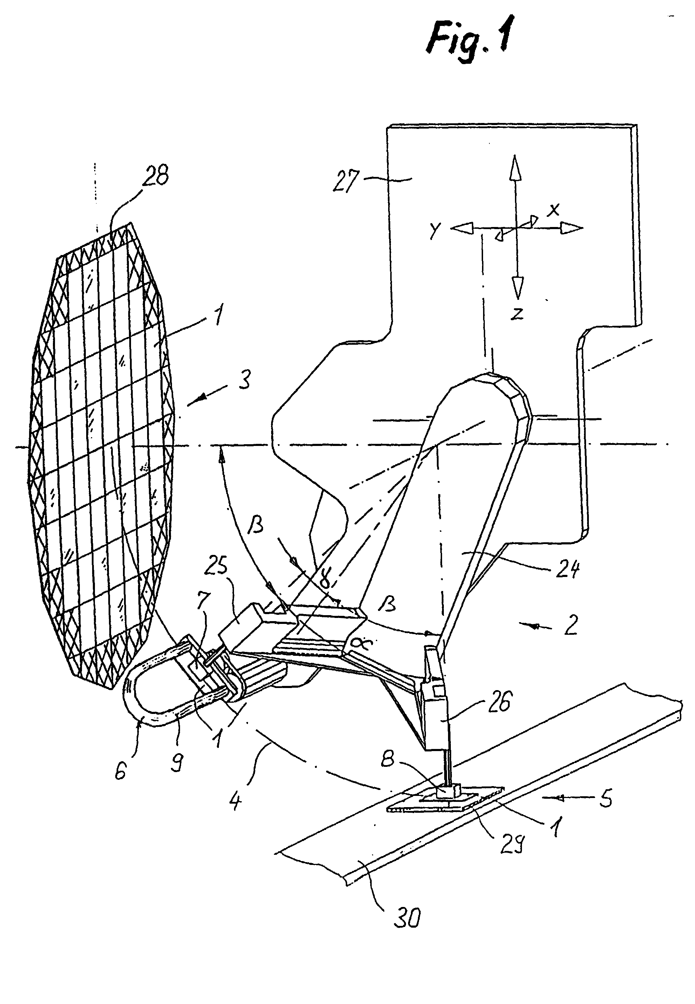

Figur 1 zeigt beispielsweise die Arbeitsstation eines Chip-Bestückungsautomaten, bei dem von einem in der Aufnahmeebene 3 eingespannten Wafer 28 einzelne Chips 1 abgenommen und auf eine Unterlage 29 aufgesetzt werden müssen, welche auf einer Transportvorrichtung 30 taktweise vorbeigeführt wird. Die Unterlage 29 verläuft dabei in der Abgabeebene 5. Die Aufnahmeebene 3 und die Abgabeebene 5 sind im rechten Winkel zueinander angeordnet, so dass ein einzelner Chip 1 auf einem Zustellweg 4 eine Schwenkbewegung von insgesamt 90° zurücklegen muss. Der Zustellweg wird mit Hilfe einer Transfereinheit 2 zurückgelegt, die hier als Schwenkarm 24 ausgebildet ist. Die Transfereinheit ist an einem Schlitten 27 befestigt, der in den Raumachsen x, y und z bewegt werden kann, so dass die Transfereinheit jede beliebige Koordinate auf der Aufnahmeebene und/oder auf der Abgabeebene anfahren kann. Die Technik der Chip-Verarbeitung an einem sogenannten Die-Bonder ist dem Fachmann grundsätzlich bekannt und wird daher hier im Einzelnen nicht wiederholt.

Die Transfereinheit 2 ist mit zwei Arbeitsköpfen versehen, nämlich mit einem Aufnahmekopf 7 und mit einem Absetzkopf 8. Die beiden Köpfe sind an den Teilarmen 25 und 26 auf der gleichen Schwenkebene unter einem Werkzeugwinkel ∝ von z.B 50° versetzt zueinander angeordnet. Der Schwenkarm 24 kann um einen Schwenkwinkel β von z.B. 40° geschwenkt werden, wobei ersichtlicherweise die beiden Werkzeugköpfe 7 und 8 sich in ihrer winkelmässigen Bewegung nie überlappen, sondern stets um einen Differenzwinkel y von z.B. 10° voneinander entfernt bleiben. Der Aufnahmekopf 7 und der Absetzkopf 8 sind auf an sich bekannte Weise so ausgebildet, dass noch eine kleine Hubbewegung zum Aufnehmen bzw. zum Absetzen zurückgelegt werden kann. Die Köpfe arbeiten pneumatisch und halten einen Chip 1 auf dem Zustellweg mit Unterdruck bzw. lösen ihn mit Ueberdruck wieder vom Kopf ab. Denkbar wären selbstverständlich auch Köpfe, welche ein Werkstück mit anderen Mitteln, beispielsweise mit elektromagnetischen Mitteln, ergreifen und ablösen können.

Der Antrieb für den Schwenkarm 24 kann auf verschiedene Art und Weise erfolgen. Vorzugsweise wird die Schwenkbewegung durch ein Maltesergetriebe gesteuert, so dass die jeweilige Winkelposition sehr langsam angefahren wird. Derartige Getriebe sind dem Fachmann jedoch ebenfalls bekannt und werden hier nicht näher beschrieben.

Im Bereich des Zustellwegs 4 ist eine Zwischenstation 6 auf anschliessend noch näher beschriebene Art und Weise am Schlitten 27 befestigt. Diese Zwischenstation verfügt über Greifmittel 9, mit deren Hilfe ein Chip 1 im Randbereich eingespannt und festgehalten werden kann. Beim Zurücklegen des Schwenkwinkels β transportiert der Aufnahmekopf 7 einen Chip 1 jeweils nur von der Aufnahmeebene 3 zur Zwischenstation 6, während simultan der Absetzkopf 8 einen zweiten Chip von der Zwischenstation an die Abgabeebene 5 transportiert. Ersichtlicherweise muss dabei zur Aufnahme bzw. zur Abgabe eines Chips auch die Zwischenstation 6 um den Differenzwinkel y bewegt werden, weil die beiden Köpfe 7 und 8 jeweils nicht ganz die Hälfte des Zustellwegs 4 zurücklegen. Es wären allerdings Anwendungen denkbar, bei denen eine Relativbewegung der Zwischenstation nicht erforderlich ist und bei denen beide Köpfe 7 und 8 die feststehende Zwischenstation erreichen.

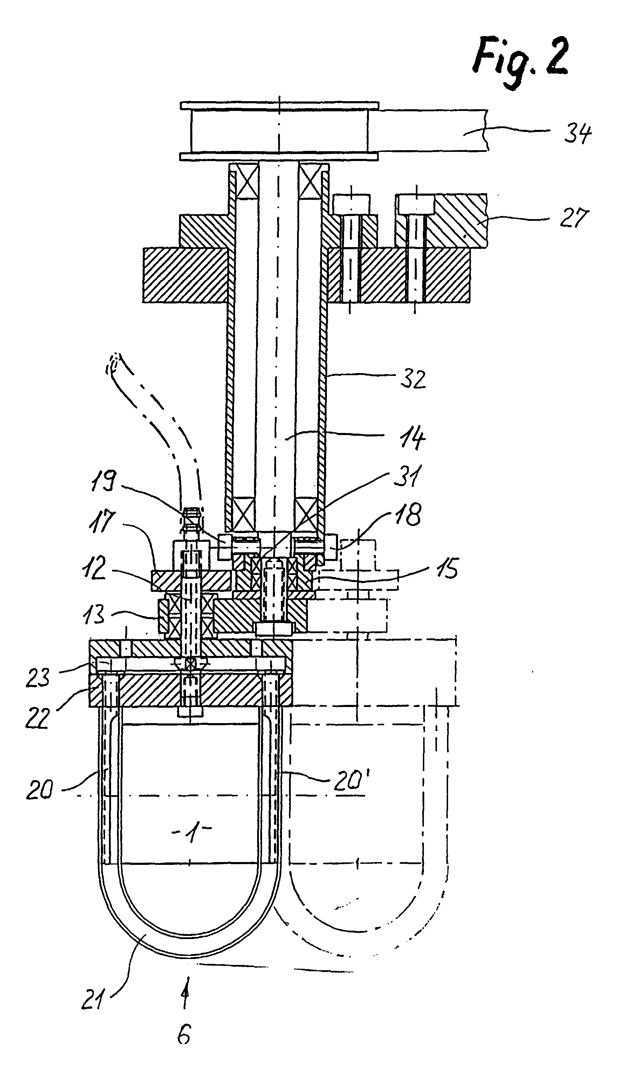

Je nachdem auf welche Weise die Zwischenstation 6 bewegt wird und dabei den Differenzwinkel γ zurücklegt, wird ein an seiner Oberseite oder Aktivseite angefasster Chip 1 vollständig gedreht, so dass er durch den Absetzkopf 8 an seiner Unterseite angefasst wird, oder aber der Chip bleibt in seiner Relativlage gleich und wird vom Absetzkopf 8 wiederum an seiner Oberseite oder Aktivseite erfasst. Beide Betriebsarten sind mit der dargestellten Vorrichtung möglich und für die Umrüstung sind nur einfache Handgriffe erforderlich. Einzelheiten der Funktion dieser Zwischenstation sind aus Figur 2 ersichtlich.

Die Zwischenstation 6 ist um eine Drehachse 12 um die eigene Achse drehbar an einem Schwenkhebel 13 gelagert. Die Drehachse 12 ist als Hohlachse ausgebildet, welche auch noch dazu dient, die pneumatischen Greifmittel mit Druck bzw. mit Vakuum zu versorgen. Der Schwenkhebel 13 ist mit einer Schwenkhebelachse 14 verbunden, die beispielsweise mittels Wälzlagern in einer Lagerbüchse 32 gelagert ist. Der Drehantrieb erfolgt über ein Riemengetriebe 34, das vorzugsweise mit dem Antrieb für den Schwenkarm 24 (Figur 1) gekoppelt ist.

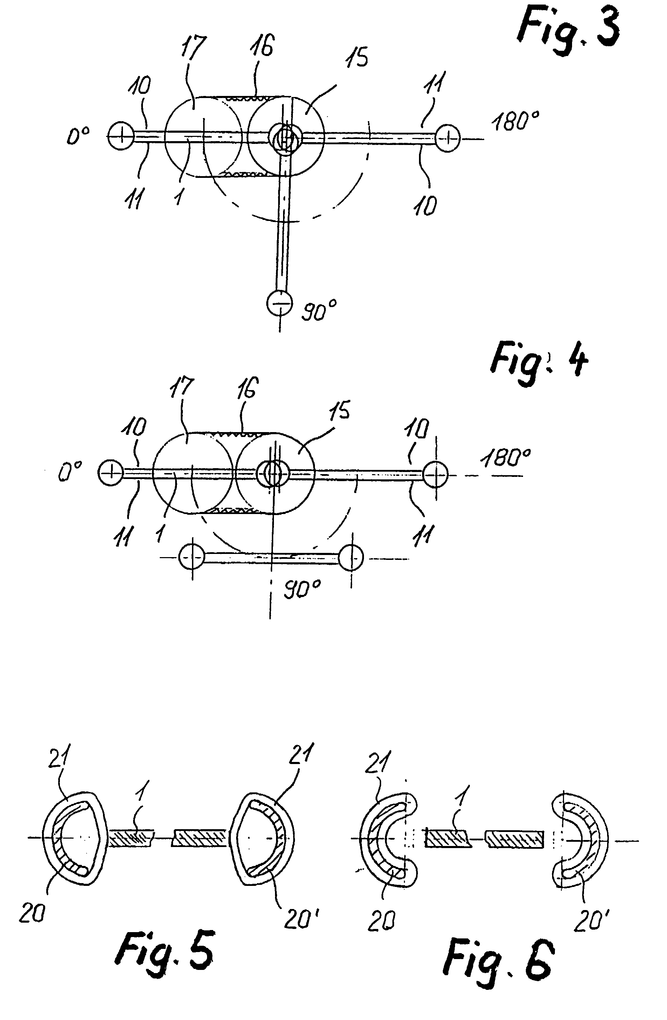

Eine getriebemässige Verbindung zwischen der Schwenkhebelachse 14 und der Drehachse 12 erfolgt über ein Antriebsrad 15 und ein Abtriebsrad 17. Da die Drehbewegung dieser Räder gleichsinnig sein muss, sind sie über einen Zahnriemen 16 (Figuren 3 und 4) miteinander gekoppelt. Es wäre aber auch denkbar Zwischenräder einzuschalten. Das Antriebsrad 15 ist über ein Wälzlager 31 derart auf der Schwenkhebelachse 14 gelagert, dass es gegenüber dieser frei drehbar ist. Mittels einer Klemmschraube 19 kann das Antriebsrad jedoch kraftschlüssig mit der Schwenkhebelachse 14 verbunden werden. Alternativ kann das Antriebsrad 15 aber auch mittels einer Klemmschraube 18 gegenüber der Schwenkhebelachsen-Lagerung arretiert werden. Alternativ zu den Klemmschrauben kann die Arretierung selbstverständlich auch mit anderen konstruktiven Mitteln erzielt werden, wie z.B. mit einer Ractvorrichtung oder dergleichen. Diese beiden Betriebsarten des Antriebsrads 15 bewirken zwei verschiedene Relativbewegungen der Zwischenstation 6, die in den Figuren 3 und 4 dargestellt sind. Diese Figuren zeigen stark schematisiert eine Draufsicht in Richtung der Drehachse 12 bzw. der Schwenkhebelachse 14 mit dem Antriebsrad 15, dem Zahnriemen 16 und dem Abtriebsrad 17. Zwischen den Greifmitteln eingespannt ist ein Chip 1 mit einer Oberseite 10 und mit einer Unterseite 11. Dargestellt sind jeweils drei Schwenkpositionen des Schwenkhebels 13 um 0°, 90° und 180°.

Wird das Antriebsrad 15 mittels der Klemmschraube 19 gegenüber der Schwenkhebelachse 14 arretiert, so dreht es sich zusammen mit dieser und der Zahnriemen 16 überträgt keine Drehbewegung auf das Abtriebsrad 17. Die Drehachse 12 steht somit still und die Lage der Zwischenstation 6 bleibt insgesamt relativ zum Schwenkhebel 13 unverändert. Ein eingespannter Chip 1 wird dabei um 180° gewendet, so dass die Unterseite 11 jetzt oben und die Oberseite 10 unten liegt. Diese Situation ist in Figur 3 dargestellt. Anders verhält es sich, wenn das Antriebsrad 15 mittels der Klemmschraube 18 relativ zur Lagerung der Schwenkhebelachse 14 arretiert wird. In diesem Fall dreht sich die Drehachse 12 mit dem Abtriebsrad 17 um das stillstehende Antriebsrad 15, wobei über den Zahnriemen 16 eine relative Drehbewegung auf das Abtriebsrad 17 ausgeübt wird. Das Uebersetzungsverhältnis ist dabei so gewählt, dass durch diese Relativbewegung die Zwischenstation 6 planparallel verschwenkt wird, wie in Figur 4 dargestellt. Sowohl in der 90°-Position, als auch in der 180°-Position ist die Oberseite 10 immer oben und die Unterseite 11 immer unten. In beiden Betriebsarten gemäss den Figuren 3 und 4 legt die Zwischenstation 6 bezogen auf den Zustellweg 4 gemäss Figur 1 den Differenzwinkel γ von 10° zurück.

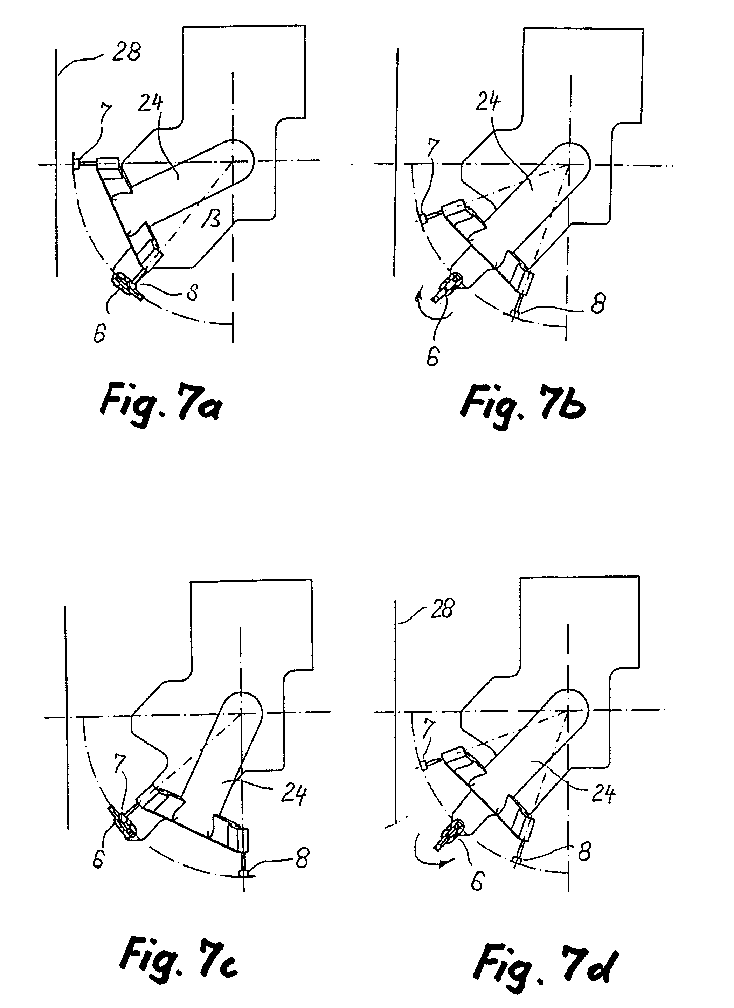

Einzelheiten der Greifmittel an der Zwischenstation 6 werden anhand der Figuren 2, 5 und 6 erläutert. Die Greifmittel bestehen aus zwei im Abstand angeordneten und einander zugewandten Stützprofilen 20 und 20' mit c-förmigem Querschnitt. Diese Profile werden durch Rohre gebildet, deren Mantel bereichsweise ausgeschnitten ist. Die Rohransätze sind dabei in eine Halterung 22 eingesetzt, die einen Hohlraum 23 aufweist. Die als Hohlachse ausgebildete Drehachse 12 steht mit diesem Hohlraum in Wirkverbindung. Auf die beiden Stützprofile 20 und 20' ist ein flexibler Schlauch 21 aufgeschoben und zwar so, dass die beiden parallelen Schlauchabschnitte auf den Stützprofilen bogenförmig miteinander verbunden sind. Der Abstand zwischen den Stützprofilen ist so gewählt, dass ein Chip 1 bei aufgeblähtem Schlauch an den parallelen Seitenkanten erfasst werden kann, wie dies in Figur 5 dargestellt ist. Wird der Schlauch unter Vakuum zusammengezogen, passt er sich der Konfiguration der Stützprofile 20 und 20' an und der Chip 1 wird freigegeben (Figur 6). Druck und Vakuum werden über eine entsprechende Steuerung zum richtigen Zeitpunkt über die Drehachse 12 angelegt.

Anhand der Figuren 7a bis 7d wird nachstehend in vier Sequenzen der Betrieb der Vorrichtung im sogenannten Flip-Mode beschrieben, bei dem ein Chip mit seiner Aktivseite nach unten auf eine Unterlage abgelegt wird. Figur 7a zeigt den Arbeitstakt, bei dem der Aufnahmekopf 7 einen Chip 1 vom Wafer 28 abgehoben hat. Gleichzeitig greift der Absetzkopf 8 einen Chip an der Zwischenstation 6. Der Schwenkarm 24 beginnt seinen Schwenkwinkel β von 40°.

In Figur 7b hat der Schwenkarm 24 den halben Schwenkwinkel von 20° zurückgelegt. Beide Werkzeugköpfe 7 und 8 halten je einen Chip und die Zwischenstation 6 schwenkt zurück in die Aufnahmelage, wobei sie die 90°-Position gemäss Figur 3 einnimmt. Diese Position entspricht in Wirklichkeit keinem Arbeitstakt, sondern wird im Verlaufe einer kontinuierlichen Bewegung nur einmal durchlaufen.

Figur 7c zeigt den Arbeitstakt, bei dem der volle Schwenkwinkel zurückgelegt wurde. Der Absetzkopf 8 hat seinen Chip in die Endposition gebracht, in der er auf die Abgabeebene abgesetzt werden kann. Gleichzeitig ist auch die Zwischenstation 6 vollständig in die Aufnahmeposition zurückgeschwenkt und kann nun mit ihren Greifmitteln den Chip übernehmen, der vom Aufnahmekopf 7 in der richtigen Position bereitgestellt wird.

Figur 7d zeigt den Schwenkarm 24 beim Zurückschwenken im halben Schwenkwinkel analog zur Figur 7b. Aufnahmekopf 7 und Absetzkopf 8 sind jedoch leer. Die mit einem Chip bestückte Zwischenstation 6 schwenkt in die Aufnahmeposition zurück und wendet dabei den Chip über Kopf. Zuletzt wird wiederum die Position gemäss Figur 7a eingenommen, in welcher der Transfervorgang von neuem beginnt.

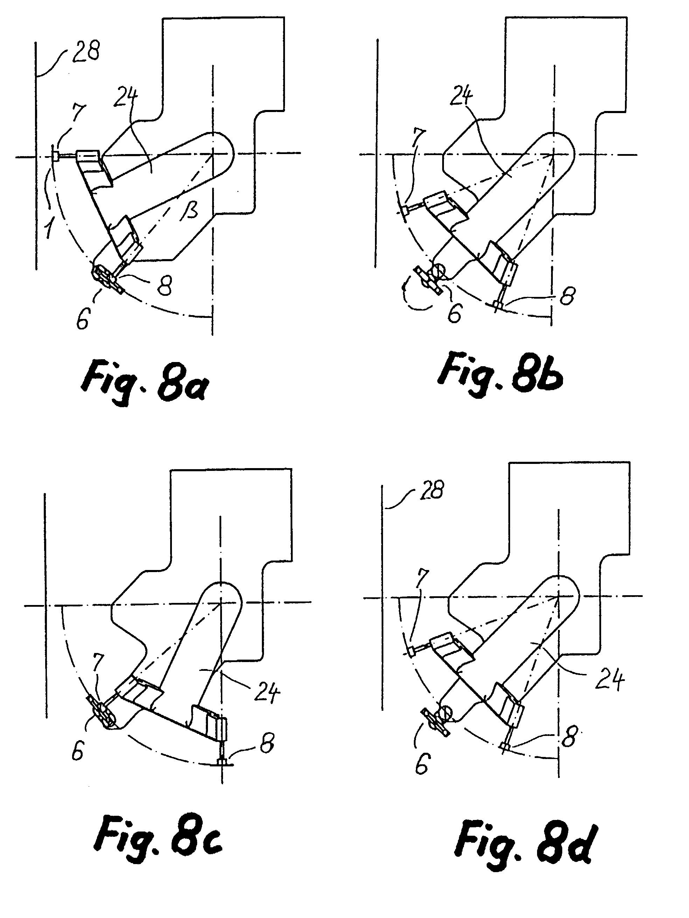

Die Figuren 8a bis 8d zeigen eine Transferbewegung im Normalbetrieb, das heisst ohne Ueberkopfdrehung des Chips. Die Ausgangsposition gemäss Figur 8a ist grundsätzlich gleich wie bei Figur 7a. Der Aufnahmekopf 7 hat vom Wafer 28 einen Chip 1 abgenommen und der Absetzkopf 8 greift den vorher an der Zwischenstation 6 eingespannten Chip.

Beim Zurückschwenken des Schwenkarms 24 auf halbem Schwenkwinkel gemäss Figur 8b sind beide Köpfe 7 und 8 mit einem Chip bestückt, die leere Zwischenstation 6 schwenkt zurück, wobei jedoch die Schwenkbewegung durch das Getriebe kompensiert wird und die Zwischenstation die 90°-Position gemäss Figur 4 einnimmt.

Gemäss Figur 8c hat der Absetzkopf 8 seine Absetzposition erreicht und die Zwischenstation 6 ist zur Aufnahme des Chips am Aufnahmekopf 7 bereit.

Beim Zurückschwenken des Schwenkarms 24 gemäss Figur 8d schwenkt auch die bestückte Zwischenstation 6 wieder in die Aufnahmeposition, jedoch ohne den Chip zu wenden. Wie in Figur 8a dargestellt, wird der Chip anschliessend wiederum an seiner Oberseite vom Absetzkopf 8 erfasst und weitertransportiert und zuletzt mit seiner Unterseite auf die Unterlage abgesetzt.

## Patentansprüche

1. Verfahren zum taktweisen Aufnehmen, Zustellen und Absetzen eines vorzugsweise flächigen Werkstücks (1) an einer Arbeitsstation, insbesondere an einem Chip-Bestükkungsautomaten, mit einer beweglichen Transfereinheit (2), wobei das Werkstück mittels der Transfereinheit an einer Oberfläche von einer Aufnahmeebene (3) aufgenommen, über einen Zustellweg (4) an eine Abgabeebene (5) zugestellt und dort abgesetzt wird, dadurch gekennzeichnet, dass das Werkstück (1) den Weg (4) in zwei Zustelltakten zurücklegt und dass es zwischen diesen Zustelltakten an einer im Bereich des Zustellwegs angeordneten Zwischenstation (6) durch im wesentlichen seitlich angreifende Greifmittel (9) festgehalten wird, wobei die Transfereinheit (2) simultan je ein Werkstück von der Aufnahmeebene (3) an die Zwischenstation (6) und von der Zwischenstation (6) an die Abgabeebene (5) transportiert und wobei die relative Seitenlage des Werkstücks (1) an der Zwischenstation (6) zwischen den Zustelltakten wahlweise verändert wird.

2. Verfahren nach Anspruch 1, dadurch gekennzeichnet, dass das Werkstück (1) an der Aufnahmeebene (3) an einer Oberseite (10) erfasst und zur Zwischenstation (6) transportiert wird und dass es an der Zwischenstation um eine beliebige Raumachse gedreht oder geschwenkt wird und an einer Unterseite (11) gefasst und mit der Oberseite (10) auf die Abgabeebene (5) abgesetzt wird.

3. Verfahren nach Anspruch 1 oder 2, dadurch gekennzeichnet, dass das Werkstück an der Zwischenstation (6) zwischen einer Aufnahmeposition, in der das Werkstück eingespannt wird und einer Abgabeposition, in der das Werkstück abgegeben wird, in seiner Relativlage bezogen auf die Abgabeebene vorwärts bewegt wird.

4. Verfahren nach einem der Ansprüche 1 bis 3, dadurch gekennzeichnet, dass das Werkstück an der Zwischenstation (6) mittels einer pneumatisch aktivierbaren Klemmvorrichtung festgehalten wird, bei welcher flexible Schlauchabschnitte zum Klemmen aufgebläht und zum Lösen zusammengezogen werden.

5. Verfahren nach einem der Ansprüche 1 bis 3, dadurch gekennzeichnet, dass das Werkstück an der Zwischenstation (6) mittels Klemmbacken festgehalten wird.

6. Vorrichtung zum taktweisen Aufnehmen, Zustellen und Absetzen eines vorzugsweise flächigen Werkstücks (1) an einer Arbeitsstation, insbesondere an einem Chip-Bestükkungsautomaten, mit einer beweglichen Transfereinheit (2), wobei das Werkstück (1) mittels der Transfereinheit an einer Oberfläche von einer Aufnahmeebene (3) aufnehmbar, über einen Zustellweg (4) an eine Abgabeebene (5) zustellbar und dort absetzbar ist, dadurch gekennzeichnet, dass die Transfereinheit (2) je einen Aufnahmekopf (7) und einen Absetzkopf (8) aufweist, dass im Bereich des Zustellweges (4) eine Zwischenstation (6) angeordnet ist, welche im wesentlichen seitlich am Werkstück (1) angreifende Greifmittel (9) aufweist, die die relative Seitenlage des Werkstücks (1) wahlweise verändern können, und dass die Transfereinheit (2) derart bewegbar ist, dass der Aufnahmekopf (7) ein Werkstück von der Aufnahmeebene (3) an die Zwischenstation und der Absetzkopf (8) simultan ein Werkstück von der Zwischenstation an die Abgabeebene (5) transportiert.

7. Vorrichtung nach Anspruch 6, dadurch gekennzeichnet, dass die Zwischenstation (6) derart um eine beliebige Raumachse drehbar und/oder schwenkbar gelagert ist, dass das Werkstück (1) an einer Oberseite (10) mit dem Aufnahmekopf (7) fassbar und in die Greifmittel einspannbar ist und dass es an einer Unterseite (11) mit dem Absetzkopf (8) fassbar und von den Greifmitteln (9) abnehmbar ist.

8. Vorrichtung nach Anspruch 7, dadurch gekennzeichnet, dass die Zwischenstation (6) drehbar an einem Schwenkhebel (13) gelagert ist, der seinerseits um eine Schwenkhebelachse (14) schwenkbar ist, und dass die Schwenkhebelachse getriebemässig mit der Drehachse derart verbunden ist, dass beim Schwenken des Schwenkhebels die Drehachse wahlweise stillsteht oder sich dreht.

9. Vorrichtung nach Anspruch 8, dadurch gekennzeichnet, dass auf der Schwenkhebelachse (14) ein Antriebsrad (15) für das Drehachsengetriebe gelagert ist, das entweder gegenüber der Schwenkhebelachse (14) oder gegenüber dem Lager für die Schwenkhebelachse arretierbar ist.

10. Vorrichtung nach Anspruch 9, dadurch gekennzeichnet, dass das Drehachsengetriebe ein Zahnriemengetriebe ist.

11. Vorrichtung nach einem der Ansprüche 6 bis 10, dadurch gekennzeichnet, dass die Greifmittel (9) wenigstens eine flexible Berührungsfläche aufweisen, welche zum Ergreifen des Werkstücks (1) unter Druck aufblähbar und zum Loslassen des Werkstücks unter Vakuum zusammenziehbar ist.

12. Vorrichtung nach Anspruch 11, dadurch gekennzeichnet, dass die Greifmittel einen Festanschlag aufweisen.

13. Vorrichtung nach Anspruch 11, dadurch gekennzeichnet, dass die Greifmittel (9) zwei im Abstand angeordnete Stützprofile (20, 20') aufweisen und dass flexible Berührungsflächen durch Schlauchabschnitte (21) gebildet werden, welche über die Stützprofile geschoben sind.

14. Vorrichtung nach Anspruch 13, dadurch gekennzeichnet, dass die Stützprofile (20, 20') einseitig an einer Halterung (22) befestigt sind, dass die Schlauchabschnitte (21) mit einem Hohlraum (23) in der Halterung in Wirkverbindung stehen und dass die Halterung um eine Drehachse (12) drehbar ist, welche als Hohlachse ausgebildet ist, über die der Hohlraum (23) an eine Druckquelle oder an eine Vakuumquelle anschliessbar ist.

15. Vorrichtung nach einem der Ansprüche 6 bis 14, dadurch gekennzeichnet, dass die Aufnahmeebene (3) und die Abgabeebene (5) unter einem Winkel von vorzugsweise 90° zueinander geneigt sind und dass die Transfereinheit (2) als Schwenkarm (24) ausgebildet ist, an dem in der gleichen Schwenkebene der Aufnahmekopf (7) und der Abgabekopf (8) winkelmässig versetzt zueinander angeordnet sind.

16. Vorrichtung nach Anspruch 15, dadurch gekennzeichnet, dass der Schwenkarm (24) an einer in verschiedenen Raumachsen (x, y, z) bewegbaren Halterung (27) angeordnet ist, die auch die Zwischenstation (6) trägt.

## Claims

1. A method for the cycled receiving, placing and depositing of a preferably flat subject (1) on an operating station, in particular on a chip loading automatic machine, with a movable transfer unit (2), wherein the subject is received on one surface from a receiving plane (3) by way of a transfer unit, is placed over a placing path (4) onto a dispensing plane (5) and is here deposited, characterised in that the subject (1) covers the path (4) in two placing cycles and that between these placing calces it is held at an intermediate station (6) arranged in the region of the placing path by way of essentially laterally gripping means (9), wherein the transfer unit (2) simultaneously in each case transports a subject from the receiving plane (3) to the intermediate station (6) and from the intermediate station (6) to the dispensing plane (5), and wherein the relative lateral position of the subject (1) at the intermediate station (6) is selectively changed between the placing cycles.

2. A method according to claim 1, characterised in that the subject (1) at the receiving plane (3) is grasped at an upper side (10) and is transported to the intermediate station (6) and that is rotated or pivoted at the intermediate station about any spacial axis and is grasped on a lower side and with the upper side is deposited onto the dispensing plane (5).

3. A method according to claim 1 or 2, characterised in that the subject at the intermediate station (6) in its relative position with respect to the dispensing plane is moved forwards between a receiving position in which the subject is clamped and a dispensing position in which the subject is dispensed.

4. A method according to one of the claims 1 to 3, characterised in that the subject at the intermediate station (6) is held by way of a pneumatically activatable clamping device with which flexible tubing sections for clamping are inflated and for releasing are contracted.

5. A method according to one of the claims 1 to 3, characterised in that the subject at the intermediate station (6) is held by way of clamping jaws.

6. A device for the cycled receiving, placing and depositing of a preferably flat subject (1) on an operating station, in particular on a chip loading automatic machine, with a movable transfer unit (2), wherein the subject (1) can be received on one surface from a receiving plane (3) by way of a transfer unit, can be placed over a placing path (4) onto a dispensing plane (5) and here can be deposited, characterised in that the transfer unit (2) in each case comprises a receiving head (7) and a depositing head (8), that in the region of the placing path (8) there is arranged an intermediate station (6) which comprises gripping means (9) gripping on the subject (1) essentially laterally, and that the transfer unit (2) can be moved in a manner such that the receiving head (7) transports a subject from the receiving plane (3) to the intermediate station and the depositing head (8) transfers a subject from the intermediate station to the dispensing plane (5), wherein the relative lateral position of the subject (1) can be selectively changed.

7. A device according to claim 6, characterised in that the intermediate station (6) is mounted rotatably and/or pivotably about any spacial axis in a manner such that the subject (1) on an upper side (10) can be grasped with the receiving head (7) and clamped into the gripping means and that on a lower side (11) it can be grasped with the depositing head (8) and removed from the gripping means (9).

8. A device according to claim 7, characterised in that the intermediate station (6) is pivotably mounted on a pivoting lever (13) which for its part is pivotable about a pivoting lever axis (14), and that the pivoting lever axis is connected to the rotational axis in a geared manner and in a manner such that on pivoting the pivoting lever the rotational axis selectively stands still or rotates.

9. A device according to claim 8, characterised in that a drive wheel (15) for the rotating axes gear is mounted on the pivoting lever axis (14), this wheel being lockable with respect to the pivoting lever axis (14) or with respect to the bearing for the pivoting lever axis.

10. A device according to claim 9, characterised in that the rotating axes gear is a toothed belt gear.

11. A device according to one of the claims 6 to 10, characterised in that the gripping means (9) comprise at least one flexible contact surface which for grasping the subject (1) can be inflated under pressure and for releasing the subject can be contracted under a vacuum.

12. A device according to claim 11, characterised in that the gripping means comprise a positive stop.

13. A device according to claim 11, characterised in that the gripping means (9) comprise two support profiles (20, 20) arranged at a distance and that flexible contact surfaces are formed by tubing sections (21) which are pushed over the support profiles.

14. A device according to claim 13, characterised in that the support profiles (20, 20) are fastened on one side to a holder (22), that the tubing sections (21) are in operating connection with a cavity (23) in the holder and that the holder is rotatable about a rotational axis (12) which is formed as a hollow axis via which the hollow space (23) can be connected to a pressure source or to a vacuum source.

15. A device according to one of the claims 6 to 14, characterised in that the receiving plane (3) and the dispensing plane (5) are inclined to one another at an angle of preferably 90° and that the transfer unit (2) is formed as a pivoting arm (24) on which in the same pivoting plane the receiving head (7) and the dispensing head (8) are arranged angularly displaced to one another.

16. A device according to claim 15, characterised in that the pivoting arm (24) is arranged on a holder (27) which movable in various spacial axes (x, y, z) and which also carries the intermediate station (6).

## Revendications

1. Procédé pour recevoir, avancer et déposer une pièce (1), de préférence plate, selon un rythme, dans une station de travail, en particulier dans un automate d'équipement de microplaquettes, comprenant une unité de transfert mobile (2), procédé dans lequel, au moyen de l'unité de transfert, la pièce est reçue en provenance d'un plan de réception (3), par une surface, avancée selon un trajet d'avance (4) jusqu'à un plan de livraison (5) et y est déposée, caractérisé en ce que la pièce (1) parcourt le trajet (4) en deux temps d'avance et en ce qu'entre ces temps d'avance, elle est maintenue dans une station intermédiaire (6) disposée dans la région du trajet d'avance, par des moyens de préhension (9) qui attaquent sensiblement latéralement, l'unité de transfert (2) transportant simultanément une pièce du plan de réception (3) à la station intermédiaire (6) et une pièce de la station intermédiaire (6) au plan de livraison (5), et la position latérale relative de la pièce (1) dans la station intermédiaire (6) étant modifiée sélectivement entre les temps d'avance.

2. Procédé selon la revendication 1, caractérisé en ce que, sur le plan de réception (3), la pièce (1) est saisie par une face supérieure (10) et transportée à la station intermédiaire (6) et en ce qu'à la station intermédiaire, elle est tournée ou orientée autour d'un axe quelconque de l'espace et saisie par une face inférieure (11) et déposée par la face supérieure (10) sur le plan de livraison (5).

3. Procédé selon la revendication 1 ou 2, caractérisé en ce que, dans la station intermédiaire (6), la pièce est déplacée vers l'avant, dans sa position relative rapportée au plan de livraison, entre une position de réception, dans laquelle la pièce est serrée, et une position de livraison, dans laquelle la pièce est livrée.

4. Procédé selon l'une des revendications 1 à 3, caractérisé en ce que, dans la station intermédiaire (6), la pièce est immobilisée au moyen d'un dispositif de serrage à activation pneumatique, dans lequel des tronçons de tuyaux souples sont gonflés pour le serrage et aplatis pour la libération.

5. Procédé selon l'une des revendications 1 à 3, caractérisé en ce que, dans la station intermédiaire (6), la pièce est immobilisée par des mâchoires de serrage.

6. Dispositif pour recevoir, avancer et déposer une pièce (1), de préférence plate, selon un rythme, dans une station de travail, en particulier dans un automate d'équipement de microplaquettes, comprenant une unité de transfert mobile (2), dispositif dans lequel, au moyen de l'unité de transfert, la pièce (1) peut être reçue par une surface en provenance d'un plan de réception (3), avancée, selon un trajet d'avance (4), jusqu'à un plan de livraison (5), et peut y être déposée, caractérisé en ce que l'unité de transfert (2) présente une tête de réception (7) et une tête de dépose (8), en ce que, dans la région du trajet d'avance (4), est disposée une station intermédiaire (6) qui présente des moyens de préhension (9) qui attaquent la pièce (1) sensiblement latéralement, et qui peuvent modifier sélectivement la position latérale relative de la pièce (1), et en ce que l'unité de transfert (2) peut être déplacée de manière que la tête de réception (7) transporte une pièce du plan de réception (3) à la station intermédiaire et que la tête de dépose (8) transporte simultanément une pièce de la station intermédiaire au plan de livraison (5).

7. Dispositif selon la revendication 6, caractérisé en ce que la station intermédiaire (6) est montée pour pouvoir être tournée et/ou orientée autour d'un axe quelconque de l'espace de telle manière que la pièce (1) puisse être saisie par une face supérieure (10) avec la tête de réception (7) et puisse être serrée dans les moyens de préhension, et qu'elle puisse être saisie par une face inférieure (11) avec la tête de dépose (8) et enlevée des moyens de préhension (9).

8. Dispositif selon la revendication 7, caractérisé en ce que la station intermédiaire (6) est montée rotative sur un levier orientable (13) qui, de son côté, peut être orienté autour d'un axe (14) du levier orientable et en ce que l'axe du levier orientable est relié cinématiquement à l'axe de rotation de telle manière que, lors de l'orientation du levier orientable, l'axe de rotation soit immobile ou en rotation.

9. Dispositif selon la revendication 8, caractérisé en ce que, sur l'axe (14) du levier orientable, est montée une roue d'entraînement (15) de la transmission de l'axe de rotation, qui peut être immobilisée, soit par rapport à l'axe (14) du levier orientable, soit par rapport au palier de l'axe du levier orientable.

10. Dispositif selon la revendication 9, caractérisé en ce que la transmission de l'axe de rotation est une transmission à courroie crantée.

11. Dispositif selon l'une des revendications 6 à 10, caractérisé en ce que les moyens de préhension (9) présentent au moins une surface de contact souple qui peut être gonflée sous pression pour saisir une pièce (1) et qui peut être aplatie sous vide pour libérer la pièce.

12. Dispositif selon la revendication 11, caractérisé en ce que les moyens de préhension présentant une butée fixe.

13. Dispositif selon la revendication 11, caractérisé en ce que les moyens de préhension (9) présentent deux profilés supports (20, 20') disposés à un certain écartement et en ce que les surfaces de contact souples sont formées par des tronçons de tuyaux (21) qui sont emmanchés sur les profilés supports.

14. Dispositif selon la revendication 13, caractérisé en ce que les profilés supports (20, 20') sont fixés unilatéralement sur une monture (22), en ce que les tronçons de tuyaux (21) sont en communication effective avec une cavité (23) de la monture, et en ce que la monture peut tourner autour d'un axe de rotation (12) qui est constitué par un axe creux par l'intermédiaire duquel la cavité (23) peut être raccordée à une source de pression ou à une source de vide.

15. Dispositif selon l'une des revendications 6 à 14, caractérisé en ce que le plan de réception (3) et le plan de livraison (5) sont inclinés l'un par rapport à l'autre d'un angle qui est de préférence de 90° et en ce que l'unité de transfert (2) est constituée par un bras orientable (24) sur lequel la tête de réception (7) et la tête de livraison (8) sont disposées dans le même plan d'orientation, et décalées angulairement l'une par rapport à l'autre.

16. Dispositif selon la revendication 15, caractérisé en ce que le bras orientable (24) est agencé sur une monture (27) qui peut se déplacer dans différents axes de l'espace (x, y, z) et qui porte aussi la station intermédiaire (6).
